# EUROPÄISCHE PATENTSCHRIFT

(11) **EP 0 838 133 B1**
(45) Veröffentlichungstag und Bekanntmachung des Hinweises auf die Patenterteilung: **28.10.1998**
(21) Anmeldenummer: 97902142.5
(22) Anmeldetag: 18.02.1997
(51) Int. Cl.: H05K 1/18, H01R 9/09

(54) **VORRICHTUNG ZUR MONTAGE ELEKTRISCHER BAUTEILE AUF LEITERPLATTEN**
DEVICE FOR MOUNTING ELECTRICAL COMPONENTS ON PRINTED-CIRCUIT BOARDS
DISPOSITIF POUR MONTER DES COMPOSANTS ELECTRIQUES SUR DES CARTES DE CIRCUITS

(30) Priorität: 10.05.1996 CH 1208/96
(43) Veröffentlichungstag der Anmeldung: 29.04.1998
(73) Patentinhaber: MELCHER AG, 8610 Uster (CH)
(72) Erfinder: HUNZIKER, Hansjürg, CH-8424 Embrach (CH)
(74) Vertreter: Salgo, Reinhold Caspar, Dr.
(86) Internationale Anmeldenummer: CH9700059
(87) Internationale Veröffentlichungsnummer: WO9743883

(56) Entgegenhaltungen:
- US-A- 4 086 426
- US-A- 5 253 145
- IBM TECHNICAL DISCLOSURE BULLETIN, Bd. 32, Nr. 9B, Februar 1990, NEW YORK US, Seiten 64-65, XP000082233 "Improved area array surface mount module package"
- PATENT ABSTRACTS OF JAPAN vol. 96, no. 3, 29.März 1996 & JP 07 302655 A (IRISO DENSHI KOGYO KK), 14.November 1995,

## Beschreibung

Die vorliegende Erfindung betrifft eine Vorrichtung zur Montage elektrischer und elektronischer Bauteile auf Leiterplatten oder auf Hybriden, mit welcher unterschiedliche thermische Ausdehnungen von Bauteil und Leiterplatte respektive von Bauteil und Hybrid ausgeglichen werden können; (siehe z.B. US-A-5 253 145)) Der Begriff "Leiterplatte" schliesst in den folgenden Ausführungen Hybride (z.B. in Dickfilmtechnik) immer auch mit ein. Andererseits können die "elektronischen Bauelemente" auch aus einer weiteren Leiterplatte oder aus einem Hybrid bestehen.

Leiterplatten werden in der Regel aus glasfaserverstärktem Kunststoff oder (für die sogenannte Hybrid-Dickfilmtechnik) beispielsweise aus Aluminium-Oxid-Keramik (AOK) hergestellt. Die Anschlüsse von elektrischen oder elektronischen Bauteilen bestehen aus zusätzlichen flexiblen Drähten. Häufiger werden die Anschlüsse aber direkt durch die Anschlussstifte der Bauteile selbst gebildet. Diese Anschlussstifte werden bei der Montage durch Löcher in der Leiterplatte durchgeführt und auf der gleichen oder anderen Seite der Leiterplatte mit den dort vorhandenen Leiterbahnen mittels der Technik der Schwallötung verlötet. In Leiterplatten für oberflächenmontierbare Bauelemente (SMD) oder solchen, die aus AOK bestehen, sind Löcher aus Stabilitäts- und fertigungstechnischen Gründen, aber auch wegen der grossen Kosten, meist unerwünscht. Die Anschlüsse der Bauteile werden bei diesen Leiterplatten darum mit der sogenannten SMD-Technik stumpf auf eine Leiterbahn der Leiterplatte aufgelötet.

Dieses Verfahren ist problemlos, solange die Bauteile keine Leistung aufnehmen und den gleichen thermischen Ausdehnungskoeffizienten aufweisen wie die Leiterplatte. Andernfalls führt eine Erwärmung oder eine Abkühlung, zumal auf die in der Regel geforderten Extremwerte zwischen -40°C und +70°C, zu einer relativen Ausdehnung respektive Kontraktion des Bauteils gegenüber der Leiterplatte. Dies ist in besonders grossem Mass der Fall, wenn Leiterplatten aus konventionellem Material und AOK-Bauteile, die einen sehr geringen thermischen Ausdehnungskoeffizienten aufweisen, aufeinander befestigt werden sollen. Dabei können an den Lötstellen grosse Kräfte auftreten, die zum Unterbruch der elektrischen Verbindung und damit zur Funktionsunfähigkeit des Bauteils führen können. Entsprechende Kräfte treten immer auf, wenn das Bauteil einen anderen thermischen Ausdehnungskoeffizienten hat als die Leiterplatte, oder wenn Leiterplatte und Bauteil im Betriebszustand unterschiedliche Temperaturen annehmen.

Dieses Problem ist an sich bekannt. Zu seiner Lösung werden bei Hybrid-Kunststoff-Kombinationen in der Regel die elektrischen Anschlüsse der Bauteile als Stelzen oder als dünne, flache Bänder ausgestaltet, die entsprechend verformbar sind, wie dies in den Patentschriften JP 03'134'980 oder in EP 0'162'149 Al dargelegt ist.

Diese Lösungen weisen aber bei leistungsaufnehmenden Bauteilen, die vergleichsweise grosse Abmessungen oder eine grosse Masse haben, gewisse Nachteile auf, die beispielsweise bei einem in Multilayer-Technik aus Kunststoff-Glasfaser-Leiterplatten hergestellten Leistungs-HF-Transformator speziell stören: Durch die Stelzen resp. die Bänder kann keine genügende mechanische Stabilität der Befestigung des Bauteils erreicht werden, und thermisch induzierte oder gewöhnliche mechanische Schwingungen des Bauteils können zu mikrofonische Effekten oder zur Ermüdung von Lötstellen führen. Ausserdem ergeben sich durch diese Bauweise grosse parasitäre Induktivitäten. Weitere Nachteile liegen in der schwierigen und kostenaufwendigen Montage der Bauteile, in der unerwünscht grossen Bauhöhe und auch darin, dass die so ausgestalteten Zuleitungen relativ viel Platz auf der Leiterplatte beanspruchen. Andere Lösungen, wie z.B. die in WO 91/01041 vorgeschlagenen Feder-Halterungen für thermisch beanspruchte Bauteile, haben zusätzlich den Nachteil, dass diese Halterungen selber bereits eine grosse Masse aufweisen und viel Platz beanspruchen.

Die Aufgabe, die mit der vorliegenden Erfindung gelöst wird, besteht darin, eine Vorrichtung zur kostengünstigen, platzsparenden, nebeneffektarmen und stabilen Montage elektrischer und elektronischer Bauteile auf Leiterplatten zu finden, die die elektrischen und mechanischen Verbindungen zwischen den Leiterbahnen der Leiterplatte und dem Bauteil, insbesondere bei grossen Unterschieden in der thermischen Ausdehnung zwischen Bauteil und Leiterplatte, in einem grossen Temperaturbereich sicherstellt und es gleichzeitig ermöglicht, elektrische und elektronische Bauteile sehr kompakt herzustellen und mit geringer Bauhöhe zu montieren. Die Lösung dieser Aufgabe ist wiedergegeben im kennzeichnenden Teil des Anspruchs 1 und in den weiteren Ansprüchen 2 bis 10 betreffend bevorzugter Ausführungen der Vorrichtung. Sie wird anhand der folgenden Figuren weiter erläutert.

Es zeigen
- Fig. 1: eine perspektivische Ansicht eines Mehrschicht-HF-Transformators mit seinen Verbindungen zu einer Leiterplatte,
- Fig. 2: einen Vertikalschnitt durch eine der Verbindungen des Bauteils mit einer Leiterplatte in vergrösserter Darstellung,
- Fig. 3: einen Vertikalschnitt durch eine Variante der Verbindungen des Bauteils mit einer Leiterplatte in vergrösserter Darstellung.

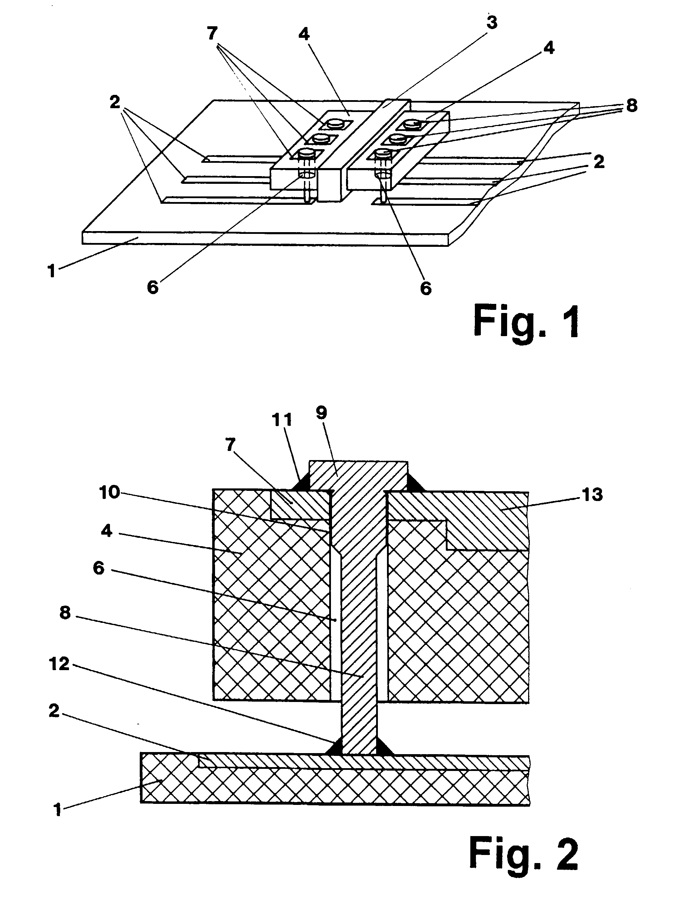

In Fig. 1 ist ein an sich bekannter Mehrschicht-HF-Transformator als Beispiel eines elektrischen oder elektronischen Bauteils 3 in perspektivischer Ansicht dargestellt. Eine Leiterplatte 1, beispielsweise aus Aluminium-Oxid-Keramik, trägt mit ihr fest verbundene Leiterbahnen 2. Das elektrische oder elektronische Bauteil 3 weist hier beispielsweise zwei Befestigungbereiche 4 auf, die mit dem Bauteil 3 fest verbunden sind. Je nach Art des Bauteils 3 können aber auch mehr als zwei Befestigungbereiche 4 vorhanden sein. Die Befestigungbereiche 4 sind flach und weisen eine Dicke auf, die mit der Leiterplatte 1 vergleichbar ist. Sie sind im wesentlichen parallel zur Ebene der Leiterplatte 1 angeordnet. Die Befestigungbereiche 4 weisen eine je nach Art des Bauteils 3 verschiedene Anzahl durchgehender Löcher 6 auf. Die Anzahl der Löcher beträgt mindestens 2, ist aber in der Regel 4 oder höher. An der der Leiterplatte 1 abgewandten Seite der Befestigungsbereiche 4 ist an jedem der Löcher 6 ein metallisches Kontaktplättchen 7 angebracht, das beispielsweise aus einem durchplattierten, metallisierten Leiterbahnstück besteht. Das Kontaktplättchen 7 ist fest mit dem jeweiligen Befestigungbereich 4 verbunden und steht mit einem der elektrischen Anschlüsse des Bauteils 3 in elektrischem Kontakt. In jedem der Löcher 6 befindet sich ein Metallstift 8, der auf seiner der Leiterplatte 1 abgewandten Seite im elektrischen Kontakt mit dem Kontaktplättchen 7 steht und mit diesem mechanisch fest verbunden ist. Auf seiner anderen Seite steht er aus dem jeweilige Befestigungbereich 4 soweit hervor, dass er mit bekannten Verfahren in einfacher Weise mit einer passenden Leiterbahn 2 der Leiterplatte 1 verlötet werden kann. Die maximale Querabmessung des Metallstifts 8 ist dabei kleiner als der Durchmesser des Lochs 6, wodurch der Metallstift 8 innerhalb des Lochs 6 eine gewisse Bewegungsfreiheit senkrecht zu seiner Längsachse bekommt. Bei Bauteilen 3 mit einer geringen Anzahl elektrisch nötiger Anschlüsse können, um die mechanische Stabilität der Verbindung zwischen Bauteil 3 und Leiterplatte 1 zu gewährleisten, auch eine Anzahl blinder Befestigungen der beschriebenen Art vorhanden sein, die mit keinem der Anschlüsse des Bauteils 3 in elektrischem Kontakt stehen.

In Fig. 2 ist ein Vertikalschnitt durch eine der Verbindungen des Bauteils 3 mit einer Leiterplatte 1 dargestellt. Er zeigt die Form des Metallstifts 8, der an seiner der Leiterplatte 1 abgewandten Seite einen Kopf 9 aufweist, dessen maximale Querabmessung grösser ist als der Durchmesser des Lochs 6. In einer nicht gezeichneten Variante enthält der Metallstift 8 an seinem oberen Ende keinen Kopf 9. In diesem Fall wird die Längenpositionierung des Metallstifts 8 mit andern Mitteln, z.B. mit Hilfe einer Montagelehre, erreicht. Mit der Unterseite des Kopfs 9 liegt der Metallstift 8 auf dem Kontaktplättchen 7 auf. Unter dem Kopf 9 weist der Metallstift 8 auf einer Länge, die der Dicke des Kontaktplättchens 7 entspricht, einen Einpressbereich 10 auf, in welchem der Metallstift 8 eine maximale Querabmessung aufweist, die etwas grösser ist als der Durchmesser des Lochs 6 im Kontaktplättchen 7. In einer bevorzugten Ausführungsform ist der Querschnitt des Metallstifts 8 im Einpressbereich 10 quadratisch. Es sind aber andere Formen der Querschnittsfläche im Einpressbereich 10 möglich, beispielsweise n-Ecke mit n≥3. In einer weiteren, nicht gezeichneten Ausführungsform verjüngt sich der Einpressbereich 10 zur Leiterplatte hin konisch. Im Verlauf der Fertigung wird der Metallstift 8 im Einpressbereich 10 in das Kontaktplättchen 7 eingepresst. Der Kopf 9 ist mit einer Lötstelle 11 im Kopfbereich zusätzlich mit dem Kontaktplättchen 7 verlötet. Auf diese Lötstelle 11 kann aber auch verzichtet werden, da durch die Einpressung bereits eine mechanisch stabile und elektrisch leitende Kaltschweiss-Verbindung zwischen Metallstift 8 und Kontaktplättchen 7, und damit mit dem ganzen Bauteil 3, erreicht wird. Die maximale Querabmessung des Metallstifts 8 ist unterhalb des Einpressbereichs 10 im wesentlichen konstant und etwas kleiner als der Durchmesser des Lochs 6, wodurch erreicht wird, dass der Metallstift 8 innerhalb des Lochs 6 die erwähnte Bewegungsfreiheit senkrecht zu seiner Längsachse bekommt. Das untere Ende des Metallstifts 8 ist an einer Lötstelle 12 im Fussbereich des Metallstifts 8 mit Hilfe der bereits erwähnten SMD-Technik stumpf auf die Leiterbahnen 2 aufgelötet. In einer nicht gezeichneten Variante sind die Metallstifte 8 durch Löcher in der Leiterplatte 1 hindurchgeführt und auf der andern Seite mit den dort vorhandenen Leiterbahnen 2 verlötet.

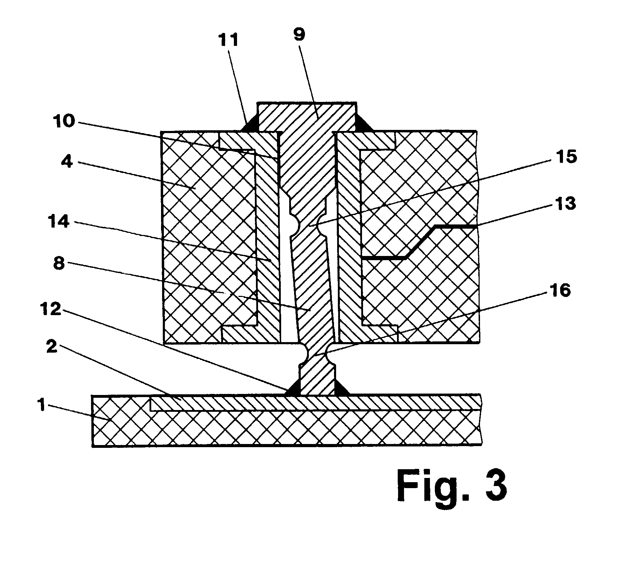

In Fig. 3 ist ein Vertikalschnitt durch eine der Verbindungen des Bauteils 3 mit einer Leiterbahn 2 der Leiterplatte 1 mit einer anderen Form des Metallstifts 8 dargestellt. Er weist in dieser Ausgestaltung knapp unterhalb seines Einpressbereichs 10 eine obere Sollbiegestelle 15 und in seinem Fussbereich eine untere Sollbiegestelle 16 auf. Diese Sollbiegestellen 15, 16 werden beispielsweise dadurch realisiert, dass die Querschnittsfläche des Metallstifts 8 über je ein kurzes Stück seiner Länge an diesen Orten reduziert ist. Dadurch können unterschiedliche thermische Ausdehnungen von Bauteil 3 und Leiterplatte 1 noch effizienter kompensiert werden, ohne dass die mechanische Stabilität der Verbindung wesentlich vermindert würde. In einer weiteren, nicht gezeichneten Variante weist der Metallstift 8 nur eine einzige Sollbiegestelle auf, die im wesentlichen zwischen den Sollbiegestellen 15, 16 liegt. Weiter ist in Fig. 3 auch eine Variante zur Ausgestaltung des mechanischen und elektrischen Kontakts zwischen dem Metallstift 8 und dem Bauteil 3 dargestellt. Das Innere des Lochs 6 ist hier im wesentlichen auf seiner ganzen Länge mit einer metallischen Beschichtung 14 durchplattiert. Diese Beschichtung 14 steht über die Verbindung 13 mit einem Anschluss des Bauteils 3 in elektrischem Kontakt. Der Metallstift 8 ist im Einpressbereich 10 direkt in die Beschichtung 14 eingepresst und stellt so den elektrischen und den kraftschlüssigen mechanischen Kontakt mit dem Metallstift 8 sicher, wodurch das Kontaktplättchen 7 entfällt. Dies ermöglicht es, das Bauteil 3, beispielsweise einen in Mehrschichttechnik aus Kunststoff-Glasfaser-Leiterplatten gefertigten Transformator, in sehr kompakter Form und mit geringer Bautiefe herzustellen, da die Befestigungsbereiche 4 bereits Bestandteil des Bauteils 3 selber bilden.

## Patentansprüche

1. Vorrichtung zur Montage elektrischer und elektronischer Bauteile (3) auf Leiterplatten (1), die ein anderes thermisches Ausdehnungsverhalten aufweisen als die Bauteile (3), wobei die Leiterplatten (1) verschiedene Leiterbahnen (2) enthalten, und sowohl die Bauteile (3) als auch die Leiterplatten (1) Hybride sein können, und
wobei
- das Bauteil (3) mindestens zwei flache Befestigungbereiche (4) aufweist und mit diesen fest verbunden ist,
- die flachen Befestigungbereiche (4) im wesentlichen parallel zur Ebene der Leiterplatte (1) liegen,
- jeder Befestigungbereich (4) mindestens ein durchgehendes Loch (6) aufweist, das im wesentlichen senkrecht zur Leiterplatte (1) steht,
- mindestens zwei der Löcher (6) an ihrer der Leiterplatte (1) abgewandten Seite Kontaktplättchen (7) aus Metall aufweisen, die mit dem zugehörigen Befestigungsbereich (4) fest verbunden sind und je in elektrischem Kontakt mit einem der Anschlüsse des Bauteils (3) stehen,
- mindestens zwei Metallstifte (8) vorhanden sind, die je im Innern eines der mindestens zwei Löcher (6) verlaufen und die an ihrem der Leiterplatte (1) abgewendeten Ende je mit dem zugehörigen Kontaktplättchen (7) fest und elektrisch leitend verbunden sind,
- die Metallstifte (8) an ihrem andern Ende aus dem Befestigungsbereich (4) herausragen und mit je einer Leiterbahn (2) der Leiterplatte (1) verlötet sind,
- die Metallstifte (8) im Innern der Löcher (6) eine kleinere maximale Querabmessung aufweisen als der Durchmesser des jeweiligen Loches (6), wodurch jeder Metallstift (8) eine gewisse Bewegungsfreiheit senkrecht zu seiner Längsachse hat.

2. Vorrichtung gemäss Anspruch 1, dadurch gekennzeichnet, dass
- die Löcher (6) durch die zugehörigen Kontaktplättchen (7) hindurchgehen,
- jeder der zugehörigen Metallstifte (8) an seiner der Leiterplatte (1) abgewandten Seite auf einer Länge, die der Dicke des Kontaktplättchens (7) entspricht, einen Einpressbereich (10) aufweist, in welcher der Metallstift (8) eine maximale Querabmessung aufweist, die etwas grösser ist als der Durchmesser des Lochs (6) im Kontaktplättchen (7),
- der Metallstift (8) im Einpressbereich (10) in das Kontaktplättchen (7) eingepresst ist, wodurch der Metallstift (8) im Einpressbereich (10) in einer kraftschlüssigen und elektrisch leitenden Kaltschweiss-Verbindung mit dem Kontaktplättchen (7) steht.

3. Vorrichtung gemäss Anspruch 2, dadurch gekennzeichnet, dass
- der Einpressbereich (10) des Metallstifts (8) sich zur Leiterplatte (1) hin konisch verjüngt.

4. Vorrichtung gemäss Anspruch 1, dadurch gekennzeichnet, dass
- die Metallstifte (8) an ihrem der Leiterplatte (1) abgewandten Seite je einen Kopf (9) aufweisen, dessen maximale Querabmessung grösser ist als der Durchmesser des Lochs (6),
- diese Metallstifte (8) mit der Unterseite der Köpfe (9) auf den Kontaktplättchen (7) aufliegen.

5. Vorrichtung gemäss Anspruch 4, dadurch gekennzeichnet, dass
- der Kopf (9) des Metallstifts (8) mit dem Kontaktplättchen (7) verlötet ist.

6. Vorrichtung gemäss Anspruch 1, dadurch gekennzeichnet, dass
- die unteren Enden der Metallstifte (8) mit je einer Lötstelle (12) im Fussbereich der Metallstifte (8) stumpf auf eine Leiterbahn (2) der Leiterplatte (1) aufgelötet sind.

7. Vorrichtung gemäss Anspruch 2, dadurch gekennzeichnet, dass
- das Loch (6) mit einer metallischen Beschichtung (14) durchplattiert ist,
- die Beschichtung (14) in elektrisch leitendem Kontakt mit einem der Anschlüsse des Bauteils (3) steht,
- der zugehörige Metallstift (8) im Einpressbereich (10) in einer kraftschlüssigen und elektrisch leitenden Kaltschweiss-Verbindung mit der Beschichtung (14) steht, die damit die Funktion des Kontaktplättchens (7) übernimmt.

8. Vorrichtung gemäss Anspruch 1, dadurch gekennzeichnet, dass
- der Befestigungsbereich (4) in das Bauteil (3) integriert ist.

9. Vorrichtung gemäss Anspruch 1, dadurch gekennzeichnet, dass
- mindestens einer der Metallstifte (8) unterhalb seines Einpressbereichs (10) mindestens eine Sollbiegestelle (15, 16) aufweist.

10. Vorrichtung nach einem der Ansprüche 1 - 9, dadurch gekennzeichnet, dass
- das Bauteil (3) ein in Mehrschichttechnik aus Kunststoff-Glasfaser-Leiterplatten hergestellter Transformator ist,
- die Leiterplatte (1) aus Aluminium-Oxid-Keramik besteht.

## Claims

1. An arrangement for the assembly of electrical and electronic components (3) onto circuit boards (1), which have a different coefficient of thermal expansion from the components (3), whereby the circuit boards include different conductor tracks (2), and both the components (3) and also the circuit boards can be hybrids, and
whereby
- the component (3) has at least two flat fastening areas (4) and is firmly joined to these,
- the flat fastening areas (4) lie essentially parallel to the plane of the circuit board (1),
- each fastening area has at least one through hole (6) which essentially stands perpendicular to the circuit board (1),
- at least two of the holes (6) have metal contact pads (7) on their sides away from the circuit board (1), which are firmly joined to
the associated fastening area (4) and are each in electrical contact with one of the connections of the component (3),
- at least two metal pins (8) are present, which run through each of the at least two holes (6) and which at their ends away from the circuit board (1) are each joined firmly and electrically conducting to their associated contact pads (7),
- the metal pins (8) extend out at their other ends from the fastening area (4) and are each soldered to a conductor track (2) of the circuit board (1),
- the metal pins (8) inside the holes (6) have a smaller maximum cross sectional dimension than the diameter of the hole (6) in each case, whereby each metal pin (8) has a certain freedom of movement perpendicular to its long axis.

2. An arrangement according to Claim 1, **characterised in that**
- the holes (6) pass through the associated contact pads (7)
- Each of the metal pins (8) has a press-in region (10) at the end away from the circuit board (1), which corresponds to the thickness of the contact pad (7), in which the metal pin (8) has a maximum cross sectional dimension which is somewhat greater than the diameter of the hole (6) in the contact pad (7),
- the press-in area (10) of the metal pin (8) is pressed into the contact pad (7), whereby the metal pin (8) remains in a frictional and electrically conducting cold welded connection with the contact pad (7).

3. An arrangement according to Claim 2, **characterised in that**
- the press-in region (10) of the metal pin (8) tapers conically towards the circuit board (1)

4. An arrangement according to Claim 1, **characterised in that**
- the metal pins (8) each has a head (9) on its end away from the circuit board (1), whose maximum cross sectional dimension is greater than the diameter of the hole (6),
- the undersides of the heads (9) of these metal pins (8) lie on the contact pads.

5. An arrangement according to Claim 4, **characterised in that**
- the head (9) of the metal pin (8) is soldered to the contact pad (7).

6. An arrangement according to Claim 1, **characterised in that**
- the lower ends of the metal pins (8) are each butt-soldered using a soldering position (12) in the foot area of the metal pin (8) to a conductor track (2) of the circuit board (1).

7. An arrangement according to Claim 2, **characterised in that**
- the hole (6) is through-plated with a metallic coating (14),
- the coating (14) stands in electrically conducting contact with one of the connections of the component (3),
- the press-in region (10) of the associated metal pin (8) stands in a frictional and electrically conducting connection with the
coating (14), which thereby assumes the function of the contact pad (7).

8. An arrangement according to Claim 1, **characterised in that**
- the fastening area (4) is integrated into the component (3).

9. An arrangement according to Claim 1, **characterised in that**
- at least one of the metal pins (8) has at least one intended bending position (15, 16) below its press-in position.

10. An arrangement according to one of the Claims 1 - 9, **characterised in that**
- The component (3) is a transformer produced in multilayer technique from glass fibre plastics circuit boards,
- the circuit board is comprised of aluminium oxide ceramic.

## Revendications

1. Dispositif pour le montage de composants électriques et électroniques (3) sur des cartes imprimées (1) qui présentent une dilatation thermique différente de celle desdits composants (3), les cartes imprimées (1) contenant différentes pistes conductives (2), étant précisé que les composants (3) et les cartes imprimées (1) peuvent être des éléments hybrides et que
- le composant (3) présente au moins deux zones de fixation plates (4) et est relié à demeure à celles-ci,
- les zones de fixation plates (4) sont globalement parallèles au plan de la carte imprimée (1),
- chaque zone de fixation (4) présente au moins un trou traversant (6) qui est globalement perpendiculaire à la carte imprimée (1),
- au moins deux des trous (6) présentent, sur leur côté opposé à la carte imprimée (1), des plaquettes de contact (7) en métal qui sont reliées à demeure à la zone de fixation (4) correspondante et qui sont chacune en contact électrique avec l'une des connexions du composant (3),
- il est prévu au moins deux tiges métalliques (8) qui s'étendent à l'intérieur des deux trous (6) ou plus, et dont l'extrémité opposée à la carte imprimée (1) est reliée à demeure et électriquement à la plaque de contact (7) correspondante,
- à leur autre extrémité, les tiges métalliques (8) dépassent de la zone de fixation (4) et sont reliées chacune par brasage à une piste conductive (2) de la carte imprimée (1),
- à l'intérieur des trous (6), les tiges métalliques (8) présentent une dimension transversale maximale inférieure au diamètre des trous (6), moyennant quoi la tige métallique (8) a une certaine liberté de mouvement perpendiculairement à son axe longitudinal.

2. Dispositif selon la revendication 1, caractérisé en ce que
- les trous (6) traversent complètement les plaquettes de contact (7) correspondantes,
- chacune des tiges métalliques (8) correspondantes comporte, sur son côté opposé à la carte imprimée (1) et sur une longueur correspondant à l'épaisseur de la plaquette de contact (7), une zone d'enfoncement (10) dans laquelle la tige métallique (8) présente une dimension transversale maximale légèrement supérieure au diamètre du trou (6) prévu dans la plaquette de contact (7),
- dans sa zone d'enfoncement (10), la tige métallique (8) est enfoncée dans la plaquette de contact (7), ce qui crée entre la tige métallique (8), dans sa zone d'enfoncement (10), et la plaquette de contact (7) une liaison par soudage à froid par adhérence et conductrice d'électricité.

3. Dispositif selon la revendication 2, caractérisé en ce que
- la zone d'enfoncement (10) de la tige métallique (8) va en rétrécissant suivant une forme conique vers la carte imprimée (1).

4. Dispositif selon la revendication 1, caractérisé en ce que
- sur leur côté opposé à la carte imprimée (1), les tiges métalliques (8) présentent une tête (9) dont la dimension transversale maximale est supérieure au diamètre du trou (6),
- ces tiges métalliques (8) sont posées avec le côté inférieur des têtes (9) sur les plaquettes de contact (7).

5. Dispositif selon la revendication 4, caractérisé en ce que
- la tête (9) de la tige métallique (8) est reliée par brasage à la plaquette de contact (7).

6. Dispositif selon la revendication 1, caractérisé en ce que
- l'extrémité inférieure de chaque tige métallique (8) est brasée bord à bord sur une piste conductive (2) de la carte imprimée (1) à l'aide d'un joint brasé (12) dans la zone de la base de ladite tige métallique (8).

7. Dispositif selon la revendication 2, caractérisé en ce que
- le trou (6) est métallisé à l'aide d'un revêtement métallique (14),
- le revêtement (14) est en contact électrique avec l'une des connexions du composant (3),
- une liaison par soudage à froid par adhérence et conductrice d'électricité est réalisée entre la tige métallique (8) correspondante, dans sa zone d'enfoncement (10), et le revêtement (14), laquelle liaison assure ainsi la fonction de la plaquette de contact (7).

8. Dispositif selon la revendication 1, caractérisé en ce que
- la zone de fixation (4) est intégrée au composant (3).

9. Dispositif selon la revendication 1, caractérisé en ce que
- l'une au moins des tiges métalliques (8) présente, au-dessous de sa zone d'enfoncement (10), au moins un point de flexion (15, 16).

10. Dispositif selon l'une des revendications 1 à 9, caractérisé en ce que
- le composant (3) consiste en un transformateur fabriqué selon la technique multicouche à partir de cartes imprimées matière plastique-fibres de verre,
- la carte imprimée (1) se compose de céramique à base d'oxyde d'aluminium.
